# EUROPEAN PATENT APPLICATION

(11) **EP 4 741 748 A1**
(43) Date of publication of application: **13.05.2026**
(21) Application number: 25201231.5
(22) Date of filing: 09.09.2025
(51) Int. Cl.: F27D 7/02, F27D 7/06, F27D 17/20, F27D 19/00, F27D 21/00, F27B 17/00

(54) **FURNACE TUBE AND USING METHOD THEREOF**

(30) Priority: 12.11.2024 CN 202411615163
(71) Applicant: SwaySure Technology Co., Ltd., Shenzhen (CN)
(72) Inventor: WANG, Huaiqing, Shenzhen (CN); WU, Tianli, Shenzhen (CN)
(74) Representative: Klunker IP Patentanwälte PartG mbB

(57) **Abstract**

A furnace tube and a using method of the same are provided. The furnace tube comprises a chamber for processing a wafer; a normal-pressure gas intake device and a low-pressure gas intake device configured to supply gas to the chamber, wherein each of the normal-pressure gas intake device and the low-pressure gas intake device is independently connected to the chamber; a normal-pressure control device and a low-pressure control device configured to control an air pressure in the chamber, wherein each of the normal-pressure control device and the low-pressure control device is configured to independently control the air pressure in the chamber; and a normal-pressure gas injection pipe located inside the chamber and connected to the normal-pressure gas intake device, and a low-pressure gas injection pipe located inside the chamber and connected to the low-pressure gas intake device. The present disclosure achieves compatibility of normal-pressure and low-pressure process treatment through one furnace tube.

## Description

### TECHNICAL FIELD

The present disclosure relates to the field of semiconductor technology, and specifically to a furnace tube and a using method of the same.

### BACKGROUND

In the manufacturing process of semiconductor chips, as an indispensable equipment, furnace tubes can be used in processes such as deposition, diffusion, oxidation and annealing on wafers.

In the related art, furnace tubes can only achieve either normal-pressure control or low-pressure control independently, that is, there are only normal-pressure furnace tubes or low-pressure furnace tubes.

In view of the presence of the above technical problems, the present disclosure provides a new furnace tube and a use method thereof to at least partially solve the above problems.

### SUMMARY

A series of simplified concepts is introduced into the portion of Summary, which would be further illustrated in the portion of the detailed description. The Summary of the present disclosure does not mean attempting to define the key feature and essential technical feature of the claimed technical solution, let alone determining the protection scope thereof.

In view of the existing problems, the present disclosure provides a furnace tube, comprising:
a chamber for processing a wafer;
a normal-pressure gas intake device and a low-pressure gas intake device configured to supply gas to the chamber, wherein each of the normal-pressure gas intake device and the low-pressure gas intake device is independently connected to the chamber;
a normal-pressure control device and a low-pressure control device configured to control an air pressure inside the chamber, wherein each of the normal-pressure control device and the low-pressure control device is configured to independently control the air pressure in the chamber;
a normal-pressure gas injection pipe located inside the chamber and connected to the normal-pressure gas intake device, and a low-pressure gas injection pipe located inside the chamber and connected to the low-pressure gas intake device.

In some embodiments of the present disclosure, the chamber comprises a gas inlet end and a gas outlet end;
wherein the normal-pressure gas intake device is connected to the normal-pressure gas injection pipe via the gas inlet end, and the low-pressure gas intake device is connected to the low-pressure gas injection pipe via the gas inlet end;
wherein the normal-pressure control device and the low-pressure control device are connected to the gas outlet end, respectively.

In some embodiments of the present disclosure, the low-pressure control device comprises:
a first main exhaust pipe, a first branch exhaust pipe, a second branch exhaust pipe and a second main exhaust pipe for providing a gas channel, wherein a gas inlet end of the first main exhaust pipe is connected to the gas outlet end, gas inlet ends of the first branch exhaust pipe and the second branch exhaust pipe are respectively connected to an exhaust end of the first main exhaust pipe, and exhaust ends of the first branch exhaust pipe and the second branch exhaust pipe are respectively connected to a gas inlet end of the second main exhaust pipe;
a main valve for controlling the air pressure inside the chamber when the chamber is in a process state, wherein the main valve is provided on the first branch exhaust pipe;
a bypass pneumatic valve for controlling the air pressure inside the chamber when the chamber is in a non-process state, wherein the bypass pneumatic valve is provided on the second branch exhaust pipe;
a vacuum pump for pumping gas inside the chamber, wherein an end of the vacuum pump is connected to the exhaust end of the second main exhaust pipe and another end of the vacuum pump is connected to an exhaust gas treatment device.

In some embodiments of the present disclosure, the normal-pressure control device comprises:
a third main exhaust pipe, a mixed drainage pipe, a drain pipe, a first branch exhaust pipe, a second branch exhaust pipe, a third branch exhaust pipe and a fourth branch exhaust pipe, wherein an exhaust end of the third main exhaust pipe is connected to an end of a condenser, another end of the condenser is connected to an inlet of the mixed drainage pipe, outlets of the mixed drainage pipe are respectively connected to an inlet of the drain pipe and gas inlet ends of the first branch exhaust pipe, the second branch exhaust pipe, the third branch exhaust pipe and the fourth branch exhaust pipe, and exhaust ends of the first branch exhaust pipe, the second branch exhaust pipe, the third branch exhaust pipe and the fourth branch exhaust pipe are respectively connected to the exhaust gas treatment device;
wherein the drain pipe is provided with a water tank and a pneumatic valve , the first branch exhaust pipe is provided with a pneumatic valve and an absolute pressure control valve, the second branch exhaust pipe is provided with a pneumatic valve and a relative pressure control valve, the third branch exhaust pipe is provided with an automatic valve and a one-way valve, and the fourth branch exhaust pipe is provided with a pneumatic valve;
wherein the relative pressure control valve is used to control an air pressure inside the chamber when a temperature inside the chamber is higher than a first set temperature;
wherein the absolute pressure control valve is used to control the air pressure inside the chamber when the temperature inside the chamber is lower than or equal to the first set temperature.

In some embodiments of the present disclosure, the normal-pressure gas injection pipe comprises a main body portion extending in a height direction of the chamber and a connection portion connected to the normal-pressure gas intake device, wherein the main body portion is evenly provided a plurality of nozzles, the gas inlet end is located at a bottom of the chamber, sizes of the nozzles increases with their distances from the gas inlet end, such that nozzles farther from the gas inlet end are larger in size, and a height of the uppermost nozzle is greater than or equal to a height of an uppermost wafer in the chamber.

In some embodiments of the present disclosure, the low-pressure gas injection pipe is L-shaped, wherein an end of the low-pressure gas injection pipe is connected to the low-pressure gas intake device, and another end of the low-pressure gas injection pipe is a gas outlet extending upward in a height direction of the chamber, and a height of the low-pressure gas injection pipe is lower than a height of a lowest wafer in the chamber.

In some embodiments of the present disclosure, the normal-pressure gas intake device comprises:
a first nitrogen gas supply pipe, an oxygen gas supply pipe, a hydrogen gas supply pipe, a first mixed gas supply pipe, a second mixed gas supply pipe and a third mixed gas supply pipe;
wherein exhaust ends of the first nitrogen gas supply pipe are respectively connected to gas inlet ends of a first nitrogen branch gas supply pipe and a second nitrogen branch gas supply pipe, exhaust ends of the first nitrogen branch gas supply pipe and the oxygen gas supply pipe are respectively connected to a gas inlet end of the first mixed gas supply pipe, exhaust ends of the second nitrogen branch gas supply pipe and the hydrogen gas supply pipe are respectively connected to a gas inlet end of the second mixed gas supply pipe, exhaust ends of the first mixed gas supply pipe and the second mixed gas supply pipe are respectively connected to a gas inlet end of the third mixed gas supply pipe, and an exhaust end of the third mixed gas supply pipe is connected to a gas inlet end of the normal-pressure gas injection pipe;
wherein each of the first nitrogen gas supply pipe, the oxygen gas supply pipe and the hydrogen gas supply pipe is provided with a filter, a hand valve, a pressure regulating valve and a pressure sensor in sequence, the hydrogen gas supply pipe is further provided with a pneumatic valve behind the pressure sensor, and each of the first nitrogen branch gas supply pipe and the second nitrogen branch gas supply pipe is provided with a pneumatic valve;
wherein each of the first mixed gas supply pipe and the second mixed gas supply pipe is provided with a gas mass flow controller and a pneumatic valve, and the third mixed gas supply pipe is provided with an igniter.

In some embodiments of the present disclosure, the low-pressure gas intake device comprises:
a second nitrogen gas supply pipe, a fluorine gas supply pipe, a special gas supply pipe, a fourth mixed gas supply pipe, a fifth mixed gas supply pipe, a sixth mixed gas supply pipe, a first mixed branch gas supply pipe, a second mixed branch gas supply pipe, a third mixed branch gas supply pipe and a fourth mixed branch gas supply pipe;
wherein exhaust ends of the second nitrogen gas supply pipe are respectively connected to gas inlet ends of the third nitrogen branch gas supply pipe and the fourth nitrogen branch gas supply pipe, exhaust ends of the third nitrogen branch gas supply pipe and the fluorine gas supply pipe are respectively connected to a gas inlet end of the fourth mixed gas supply pipe, exhaust ends of the fourth nitrogen branch gas supply pipe and the special gas supply pipe are respectively connected to a gas inlet end of the fifth mixed gas supply pipe, exhaust ends of the fourth mixed gas supply pipe are respectively connected to gas inlet ends of the first mixed branch gas supply pipe and the second mixed branch gas supply pipe, exhaust ends of the fifth mixed gas supply pipe are respectively connected to gas inlet ends of the third mixed branch gas supply pipe and the fourth mixed branch gas supply pipe, exhaust ends of the first mixed branch gas supply pipe and the third mixed branch gas supply pipe are connected to a gas inlet end of the sixth mixed gas supply pipe, a gas outlet end of the sixth mixed gas supply pipe is connected to a gas inlet end of the low-pressure gas injection pipe, and exhaust ends of the second mixed branch gas supply pipe and the fourth mixed branch gas supply pipe are respectively connected to the second main exhaust pipe;
wherein the second nitrogen gas supply pipe is provided with a filter, a hand valve, a pressure regulating valve and a pressure sensor in sequence, the fluorine gas supply pipe is provided with a filter, a hand valve, a filter, a pressure sensor and a pneumatic valve in sequence, the special gas supply pipe is provided with a filter, a hand valve, a filter, a pressure regulating valve, a pressure sensor and a pneumatic valve in sequence, each of the third nitrogen branch gas supply pipe, the fourth nitrogen branch gas supply pipe, the first mixed branch gas supply pipe, the second mixed branch gas supply pipe, the third mixed branch gas supply pipe and the fourth mixed branch gas supply pipe is provided with a pneumatic valve, and each of the fourth mixed gas supply pipe and the fifth mixed gas supply pipe is provided with a gas mass flow controller.

In some embodiments of the present disclosure, the exhaust gas treatment device comprises at least two exhaust gas treatment chambers, and one exhaust gas treatment chamber can be switched to another exhaust gas treatment chamber when the exhaust gas treatment chamber breaks down.

According to another aspect of the present disclosure, a using method of the furnace tube is provided, comprising the steps of:

keeping the normal-pressure gas intake device and the normal-pressure control device enabled, and keeping the low-pressure gas intake device and the low-pressure control device closed, such that a wafer is subjected to an normal-pressure process in the chamber.

In some embodiments of the present disclosure, controlling a working environment in the chamber to switch from a low-pressure environment to a normal-pressure environment comprises the steps of:
controlling the low-pressure gas intake device to introduce a mixed gas of fluorine gas and nitrogen gas into the chamber to completely remove a film layer formed on an inner wall of the chamber;
disabling the controlling to the low-pressure gas intake device and the low-pressure control device, and enabling the normal-pressure gas intake device to introduce nitrogen gas, to switch the interior of the chamber from a low-pressure environment to a normal-pressure state;
enabling the normal-pressure control device.

According to another aspect of the present disclosure, a using method of the furnace tube is provided, wherein the low-pressure gas intake device and the low-pressure control device are kept enabled, and the normal-pressure gas intake device and the normal-pressure control device are kept disabled, such that a wafer is subjected to a low-pressure process in the chamber.

According to the furnace tube and the using method thereof in the embodiments of the present disclosure, by configuring the normal-pressure gas intake device for supplying gas to the chamber and the normal-pressure control device for controlling the air pressure in the chamber, the wafer can be subjected to the normal-pressure process treatment; by configuring the low-pressure gas intake device for supplying gas to the chamber and the low-pressure control device for controlling the air pressure in the chamber, the wafer can be subjected to the low-pressure process treatment, thereby achieving compatibility of the normal-pressure and low-pressure process treatment through one furnace tube.

### BRIEF DESCRIPTION OF THE DRAWINGS

The following drawings are hereby incorporated as part of the present disclosure for the understanding of the present disclosure. The embodiments of the present disclosure are illustrated and described in the drawings in order to explain the principles of the present disclosure.
FIG. 1 is a schematic structural view of a furnace tube according to an embodiment of the present disclosure.
FIG. 2 is a schematic view showing a partial structure of the furnace tube according to an embodiment of the present disclosure.
FIG. 3 is a schematic structural view of an normal-pressure control device according to an embodiment of the present disclosure.
FIG. 4 is a schematic structural view of a low-pressure control device according to an embodiment of the present disclosure.
FIG. 5 is a schematic structural view of an exhaust gas treatment device according to an embodiment of the present disclosure.
FIG. 6 is a schematic structural view of a normal-pressure gas intake device according to an embodiment of the present disclosure.
FIG. 7 is a schematic structural view of a low-pressure gas intake device according to an embodiment of the present disclosure.
FIG. 8 is a schematic structural view of a chamber and a normal-pressure gas injection pipe and a low-pressure gas injection pipe provided therein according to an embodiment of the present disclosure.
FIG. 9 is a schematic structural view of a normal-pressure gas injection pipe according to an embodiment of the present disclosure.
FIG. 10 is a schematic structural view of a low-pressure gas injection pipe according to an embodiment of the present disclosure.

### DETAILED DESCRIPTION

In the following description, numerous specific details are set forth in order to provide a more thorough understanding of the present disclosure. However, it is obvious to those skilled in this art that the present disclosure may be implemented without one or more of these details. Some technical features well-known in this art are not described in other examples in order to avoid confusion with the present disclosure.

It is to be understood that the present disclosure can be implemented in various forms but should not be construed as being limited to the embodiments set forth herein. On the contrary, these embodiments are provided to make the disclosure thorough and complete and the scope of the present disclosure be completely conveyed to those skilled in the art. In the drawings, the sizes and relative sizes of layers and regions may be exaggerated for clarity. The same reference numerals throughout represent the same elements.

It should be understood that when an element or layer is referred to as "on ...", "adjacent to ...", "connected to" or "coupled to" other elements or layers, it can be directly on, adjacent to, connected to or coupled to other elements or layers, or there can be intermediate elements or layers. On the contrary, when an element is referred to as "directly on ...", "directly adjacent to ...", "directly connected to" or "directly coupled to" other elements or layers, there are no intermediate elements or layers. It will be understood that, although the terms first, second, third, etc. may be used to describe various elements, components, regions, layers and/or parts, these elements, components, regions, layers and/or parts should not be limited by these terms. These terms are only used to distinguish one element, component, region, layer or part from another element, component, region, layer or part. Therefore, without departing from the teachings of the present disclosure, the first element, component, region, layer or part discussed below could be represented as a second element, component, region, layer or part.

Spatial relationship terms such as "under", "beneath", "below", "down", "on", "above", etc., may be used herein to describe the relationships between one element or feature and another element(s) or feature(s) shown in the figures. It should be understood that the spatial relationship terms are intended to encompass different orientations of the device in use and operation in addition to the orientation shown in the figures. For example, if the device in the figures is flipped, then the elements or features described as "under other elements" or "under" or "below" will be oriented as "on" the other elements or features. Therefore, the exemplary terms "under" and "below" may include both upper and lower orientations. The device may be oriented otherwise (rotated 90 degrees or other orientations) and the spatial descriptors used herein are interpreted accordingly.

The terminology used herein is for the purpose of describing particular embodiments only and is not intended to limit the present disclosure. When they are used herein, the singular forms "a," "an," and "the" are intended to include the plural forms as well, unless the context clearly indicates otherwise. It should also be understood that the terms "comprising" and/or "including", when used in this specification, specify the presence of the features, integers, steps, operations, elements and/or components but not to exclude the presence or addition of one or more other features, integers, steps, operations, elements, components and/or groups. When they are used herein, the terms "and/or" include any or all combinations of related listed items.

In the related art, furnace tubes can only achieve either normal-pressure control or low-pressure control independently, that is, there are only normal-pressure furnace tubes or low-pressure furnace tubes.

In order to solve at least one of the above-mentioned technical problems, the present disclosure provides a furnace tube, comprising: a chamber for processing a wafer; a normal-pressure gas intake device and a low-pressure gas intake device configured to supply gas to the chamber and independently connected to the chamber, respectively; an normal-pressure control device and a low-pressure control device configured to control an air pressure in the chamber and independently control the air pressure in the chamber, respectively; a normal-pressure gas injection pipe located inside the chamber and connected to the normal-pressure gas intake device, and a low-pressure gas injection pipe located inside the chamber and connected to the low-pressure gas intake device.

According to the furnace tube of the present disclosure, by configuring the normal-pressure gas intake device for supplying gas to the chamber and the normal-pressure control device for controlling the air pressure in the chamber, the wafer can be subjected to the normal-pressure process treatment; by configuring the low-pressure gas intake device for supplying gas to the chamber and the low-pressure control device for controlling the air pressure in the chamber, the wafer can be subjected to the low-pressure process treatment, thereby achieving compatibility of the normal-pressure and low-pressure process treatment through one furnace tube.

In order to understand the present disclosure thoroughly, a detailed step and structure is provided in the following descriptions so as to elucidate the technical solutions presented in the present disclosure. Better embodiments of the present disclosure are illustrated in detail as below. However, the present disclosure may further have other embodiments in addition to these detailed descriptions.

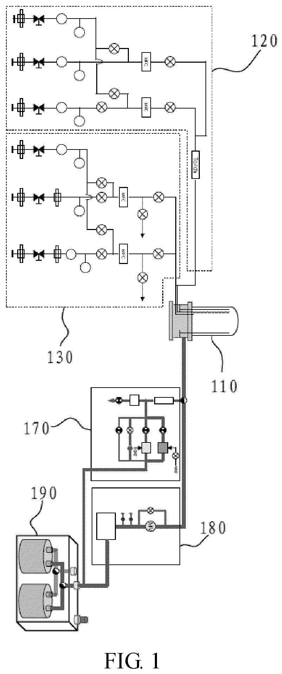

The furnace tube according to multiple embodiments of the present disclosure is described below with reference to FIGs. 1 to 10. The furnace tube comprises: a chamber 110 for processing a wafer; a normal-pressure gas intake device 120 and a low-pressure gas intake device 130 configured to supply gas to the chamber 110, wherein each of the normal-pressure gas intake device and the low-pressure gas intake device is independently connected to the chamber 110; an normal-pressure control device 170 and a low-pressure control device 180 configured to control the air pressure inside the chamber 110, wherein each of the normal-pressure control device and the low-pressure control device is configured to independently control the air pressure in the chamber 110; a normal-pressure gas injection pipe 140 located inside the chamber 110 and connected to the normal-pressure gas intake device 120, and a low-pressure gas injection pipe 150 located inside the chamber 110 and connected to the low-pressure gas intake device 130.

In the actual operation of the furnace tube in this embodiment, the normal-pressure gas intake device 120 and the normal-pressure control device 170 can be controlled to be in an enabled state, while the low-pressure gas intake device 130 and the low-pressure control device 180 are in a closed state. Thus, the air pressure in the chamber 110 can be controlled to be in the normal-pressure state through the normal-pressure control device 170, and the normal-pressure gas intake device 120 supplies gas to the chamber 110 through the normal-pressure gas injection pipe 140, enabling the wafers in the furnace tube to undergo normal-pressure process treatment. Alternatively, the low-pressure gas intake device 130 and the low-pressure control device 180 can be controlled to be in the enabled state, while the normal-pressure gas intake device 120 and the normal-pressure control device 170 can be in the closed state. Thus, the air pressure in the chamber 110 can be controlled to be in the low-pressure state through the low-pressure control device 180, and the low-pressure gas intake device 130 supplies gas to the chamber 110 through the low-pressure gas injection pipe 150, enabling the wafers in the furnace tube to undergo the low-pressure process treatment.

Accordingly, through the furnace tube of the present embodiment, the wafer can be subjected to both normal-pressure and low-pressure process treatment, thereby achieving the compatibility of normal-pressure and low-pressure process treatment through one furnace tube.

In some embodiments, the chamber 110 includes a gas inlet end and a gas outlet end. The normal-pressure gas intake device 120 is connected to the normal-pressure gas injection pipe 140 via the gas inlet end, and the low-pressure gas intake device 130 is connected to the low-pressure gas injection pipe 150 via the gas inlet end. The normal-pressure control device 170 and the low-pressure control device 180 are respectively connected to the gas outlet end.

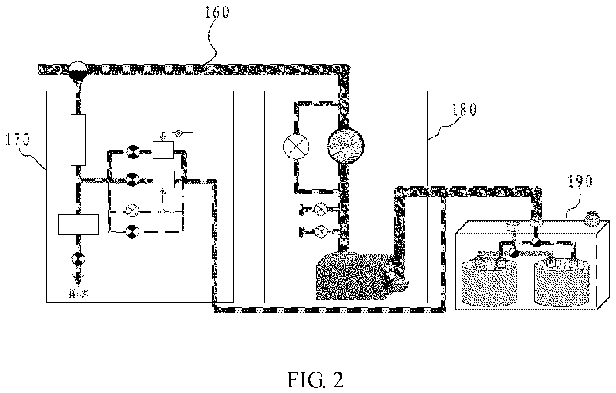

As shown in FIG. 2, a general exhaust pipe 160 is provided at the gas outlet end of the chamber 110. The normal-pressure control device 170 and the low-pressure control device 180 are respectively connected to different parts of the general exhaust pipe 160, such that they are respectively connected to the gas outlet ends of the chamber 110 via the general exhaust pipe 160, and the chamber 110 can be controlled to be in an normal-pressure state or a low-pressure state.

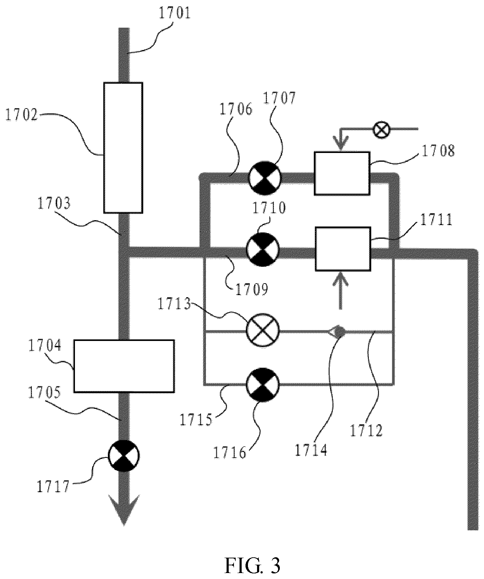

In some embodiments, as shown in FIG. 3, the normal-pressure control device 170 includes a third main exhaust pipe 1701, a mixed drainage pipe 1703, a drain pipe 1705, a first branch exhaust pipe 1706, a second branch exhaust pipe 1709, a third branch exhaust pipe 1712, and a fourth branch exhaust pipe 1715. The exhaust end of the third main exhaust pipe 1701 is connected to one end of the condenser 1702. Another end of the condenser 1702 is connected to the inlet of the mixed drainage pipe 1703. The outlets of the mixed drainage pipe 1703 are respectively connected to the inlet of the drain pipe 1705 and the gas inlet ends of the first branch exhaust pipe 1706, the second branch exhaust pipe 1709, the third branch exhaust pipe 1712 and the fourth branch exhaust pipe 1715. The exhaust ends of the first branch exhaust pipe 1706, the second branch exhaust pipe 1709, the third branch exhaust pipe 1712 and the fourth branch exhaust pipe 1715 are respectively connected to the exhaust gas treatment device 190. The drain pipe 1705 is provided with a water tank 1704 and a pneumatic valve 1717. The first branch exhaust pipe 1706 is provided with a pneumatic valve 1707 and an absolute pressure control valve 1708. The second branch exhaust pipe 1709 is provided with a pneumatic valve 1710 and a relative pressure control valve 1711. The third branch exhaust pipe 1712 is provided with an automatic valve 1713 and a one-way valve 1714. The fourth branch exhaust pipe 1715 is provided with a pneumatic valve 1716. The relative pressure control valve 1711 is used to control the air pressure inside the chamber 110 when a temperature inside the chamber 110 is higher than a first set temperature. The absolute pressure control valve 1708 is used to control the air pressure inside the chamber 110 when the temperature inside the chamber 110 is less than or equal to the first set temperature.

Specifically, when a normal-pressure control of the chamber 110 is required, it can be determined to use the relative pressure control valve 1711 or the absolute pressure control valve 1708 to control the air pressure in the chamber 110 to be in a normal-pressure state based on whether the temperature in the chamber 110 is higher than the first set temperature. For example, when the temperature in the chamber 110 is higher than the first set temperature, the first branch exhaust pipe 1706 can be controlled to be in a closed state and the second branch exhaust pipe 1709 in an open state by controlling the pneumatic valve 1707 and the absolute pressure control valve 1708 on the first branch exhaust pipe 1706 to be in the closed state, and the pneumatic valve 1710 and the relative pressure control valve 1711 on the second branch exhaust pipe 1709 to be in an open state. At this time, the gas in the chamber 110 can flow through the general exhaust pipe 160 into the third main exhaust pipe 1701 and is cooled when it passes through the condenser 1702. For example, the water vapor generated by the process can be condensed. The liquid component generated after the cooling flows through the mixed drainage pipe 1703 into the water tank 1704 on the drain pipe 1705 for storage, and can be exhausted to the outside by opening the pneumatic valve 1717 after being stored to a certain extent. The condensed gas flows through the mixed drainage pipe 1703 into the second branch exhaust pipe 1709, and then flows through the second branch exhaust pipe 1709 into the exhaust gas treatment device 190, thereby ensuring that the air pressure inside the chamber 110 is at the normal-pressure state. When the temperature in the chamber 110 is lower than or equal to the first set temperature, the second branch exhaust pipe 1709 can be controlled to be in the closed state and the first branch exhaust pipe 1706 in the open state by controlling the pneumatic valve 1707 and the absolute pressure control valve 1708 on the first branch exhaust pipe 1706 to be in the open state, and the pneumatic valve 1710 and the relative pressure control valve 1711 on the second branch exhaust pipe 1709 to be in the closed state. The absolute pressure control valve 1708 can use the principle of siphon to generate a certain amount of suction force to extract the gas in the chamber 110. By controlling the opening and closing angle of the pneumatic valve 1707 provided on the first branch exhaust pipe 1706, the pressure in the chamber 110 can be controlled to allow the gas in the chamber 110 to flow through the general exhaust pipe 160 into the third main exhaust pipe 1701 and to be cooled as it passes through the condenser 1702. For example, the water vapor generated by the process can be condensed. The liquid component generated after cooling flows through the mixed drainage pipe 1703 into the water tank 1704 on the drain pipe 1705 for storage, and can be exhausted to the outside by opening the pneumatic valve 1717 after being stored to a certain extent. The condensed gas flows through the mixed drainage pipe 1703 into the first branch exhaust pipe 1706, and then flows through the first branch exhaust pipe 1706 into the exhaust gas treatment device 190, thereby ensuring that the air pressure in the chamber 110 is at the normal-pressure state.

When the pressure inside the chamber 110 is too high, the automatic valve 1713 provided on the third branch exhaust pipe 1712 will be opened automatically, and the pressure inside the chamber 110 will be relieved via the automatic valve 1713 and the one-way valve 1714 provided on the third branch exhaust pipe 1712, thereby reducing the pressure inside the chamber 110.

When there is no need to perform process treatment on the wafer in the chamber 110, the pneumatic valve 1716 on the fourth branch exhaust pipe 1715 can be opened to vent the gas from the chamber 110 through the fourth branch exhaust pipe 1715 into the exhaust gas treatment device 190.

In FIG. 1, GN₂ introduced into the absolute pressure control valve 1708 or the relative pressure control valve 1711 denotes industrial-grade pure nitrogen, commonly referred to as General Nitrogen.

In some embodiments, the first set temperature can be set according to actual situation, for example, the first set temperature can be 1100°C or any other suitable temperature, which is not limited.

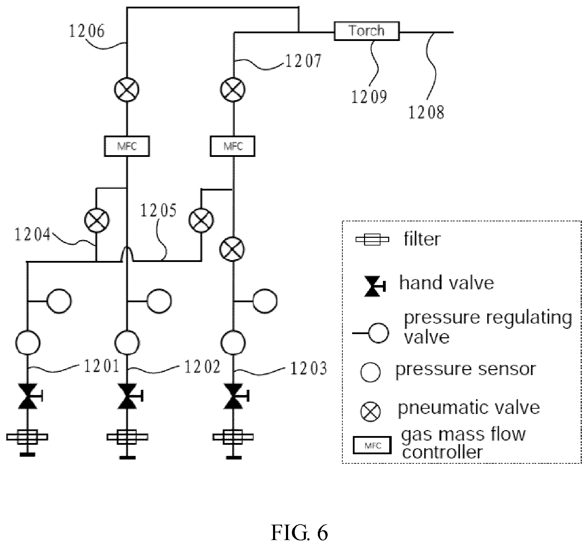

In some embodiments, as shown in FIG. 6, the normal-pressure gas intake device 120 includes a first nitrogen gas supply pipe 1201, an oxygen gas supply pipe 1202, a hydrogen gas supply pipe 1203, a first mixed gas supply pipe 1206, a second mixed gas supply pipe 1207 and a third mixed gas supply pipe 1208. The exhaust ends of the first nitrogen gas supply pipe 1201 are respectively connected to the gas inlet ends of the first nitrogen branch gas supply pipe 1204 and the second nitrogen branch gas supply pipe 1205. The exhaust ends of the first nitrogen branch gas supply pipe 1204 and the oxygen gas supply pipe 1202 are respectively connected to the gas inlet end of the first mixed gas supply pipe 1206. The exhaust ends of the second nitrogen branch gas supply pipe 1205 and the hydrogen gas supply pipe 1203 are respectively connected to the gas inlet end of the second mixed gas supply pipe 1207. The exhaust ends of the first mixed gas supply pipe 1206 and the second mixed gas supply pipe 1207 are respectively connected to the gas inlet end of the third mixed gas supply pipe 1208. The exhaust end of the third mixed gas supply pipe 1208 is connected to the gas inlet end of the normal-pressure gas injection pipe 140. Each of the first nitrogen gas supply pipe 1201, the oxygen gas supply pipe 1202 and the hydrogen gas supply pipe 1203is provided with a filter, a hand valve, a pressure regulating valve and a pressure sensor in sequence. Additionally, the hydrogen gas supply pipe 1203 is further provided with a pneumatic valve behind the pressure sensor. Each of the first nitrogen branch gas supply pipe 1204 and the second nitrogen branch gas supply pipe 1205 is provided with a pneumatic valve. Each of the first mixed gas supply pipe 1206 and the second mixed gas supply pipe 1207 is provided with a gas mass flow controller and a pneumatic valve, and the third mixed gas supply pipe 1208 is provided with an igniter 1209. The igniter 1209 can be the Torch component in FIG. 6.

Specifically, the first nitrogen gas supply pipe 1201, the oxygen gas supply pipe 1202 and the hydrogen gas supply pipe 1203 can be respectively connected to the nitrogen gas source, oxygen gas source and hydrogen gas source,. When the air pressure inside the chamber 110 is controlled to be in the normal-pressure state by the normal-pressure control device 170, nitrogen, oxygen and hydrogen can be supplied to the chamber 110 respectively via the first nitrogen gas supply pipe 1201, the oxygen gas supply pipe 1202 and the hydrogen gas supply pipe 1203. A portion of the nitrogen supplied via the first nitrogen gas supply pipe 1201 can flow through the first nitrogen branch gas supply pipe 1204 into the first mixed gas supply pipe 1206, and the oxygen supplied via the oxygen gas supply pipe 1202 can also flow into the first mixed gas supply pipe 1206. The nitrogen and oxygen are mixed in the first mixed gas supply pipe 1206. Another portion of the nitrogen supplied via the first nitrogen gas supply pipe 1201 can flow through the second nitrogen branch gas supply pipe 1205 into the second mixed gas supply pipe 1207, and the hydrogen supplied via the hydrogen gas supply pipe 1203 can also flow into the second mixed gas supply pipe 1207. The nitrogen and hydrogen are mixed in the second mixed gas supply pipe 1207. Thereafter, the mixed nitrogen and oxygen as well as the mixed nitrogen and hydrogen flow into the third mixed gas supply pipe 1208 for mixing, and then flow through the normal-pressure gas injection pipe 140 into the chamber 110 after being ignited by the igniter 1209.

The filters provided on the first nitrogen gas supply pipe 1201, the oxygen gas supply pipe 1202 and the hydrogen gas supply pipe 1203 can respectively filter the gas in their respective pipes. The hand valves provided on the first nitrogen gas supply pipe 1201, the oxygen gas supply pipe 1202 and the hydrogen gas supply pipe 1203 can respectively open and close their respective pipes such that the gas flows or stops flowing in the pipes. The pressure regulating valves provided on the first nitrogen gas supply pipe 1201, the oxygen gas supply pipe 1202 and the hydrogen gas supply pipe 1203 can respectively adjust the pressure in their respective pipes. The pressure sensors provided on the first nitrogen gas supply pipe 1201, the oxygen gas supply pipe 1202 and the hydrogen gas supply pipe 1203 can respectively detect the pressure in their respective pipes.

The gas mass flow controller provided on the first mixed gas supply pipe 1206 can precisely measure and control the mass/flow rate of the mixed nitrogen and oxygen. The gas mass flow controller provided on the second mixed gas supply pipe 1207 can precisely measure and control the mass/flow rate of the mixed nitrogen and hydrogen. Accordingly, the gas flow rate involved in the reaction in the chamber 110 can be controlled within a very precise range, allowing the reaction to proceed according to the set process parameters, which is helpful to improve the consistency and quality of the products. Taking chemical vapor deposition in silicon wafer manufacturing as an example, precisely controlling the mass flow of the reaction gas can ensure that the film deposited on the silicon wafer is uniform in thickness and stable in performance.

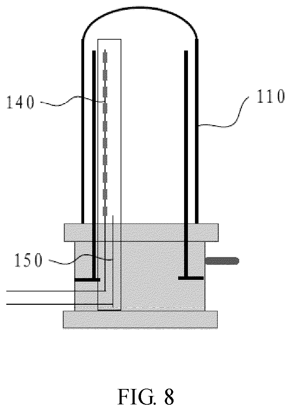

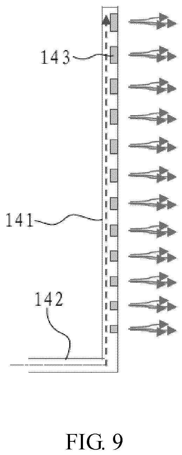

In some embodiments, as shown in FIGS. 8 and 9, the normal-pressure gas injection pipe 140 includes a main body portion 141 extending in the height direction of the chamber 110 and a connection portion 142 connected to the normal-pressure gas intake device 120. The main body portion 141 is evenly provided with a plurality of nozzles 143. The gas inlet end is located at the bottom of the chamber 110. The sizes of the nozzles 143 increase with their distances from the gas inlet end, such that the nozzles 143 farther from the gas inlet end are larger in size. The height of the uppermost nozzle 143 is greater than or equal to the height of the uppermost wafer in the chamber 110.

Specifically, after the mixed gas in the third mixed gas supply pipe 1208 flows through the connection portion 142 of the normal-pressure gas injection pipe 140 into the main body portion 141 thereof, it can flow through the plurality of nozzles 143 provided from bottom to top on the main body portion 141 into the chamber 110. The flow direction of the gas is shown by the dotted arrows and solid arrows in FIG. 9. As the mixed gas passes through the plurality of nozzles 143 provided from bottom to top on the main body portion 141 in sequence, the flow rate of the mixed gas decreases gradually. In this embodiment, since the plurality of nozzles 143 provided on the main body portion 141 increase in size from bottom to top, the drawback of the gradual decrease in the flow rate of the mixed gas can be compensated for ensuring that the gas flow rate sprayed into the chamber 110 by each nozzle 143 is uniform and consistent, thereby balancing the gas flow within the chamber 110 and playing a role in controlling the uniformity of the product film thickness.

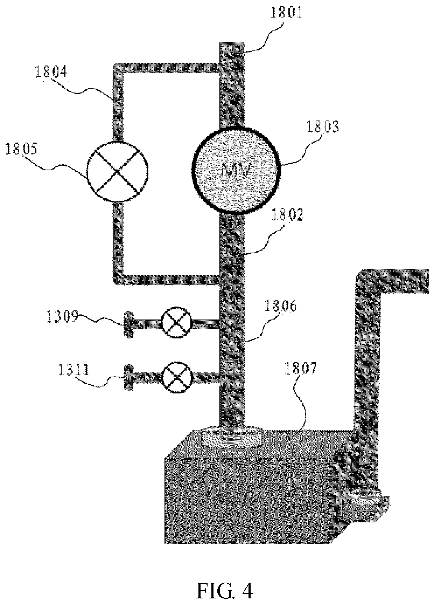

In some embodiments, as shown in FIG. 4, the low-pressure control device 180 includes a first main exhaust pipe 1801, a first branch exhaust pipe 1802, a second branch exhaust pipe 1804 and a second main exhaust pipe 1806 for providing a gas channel. The gas inlet end of the first main exhaust pipe 1801 is connected to the gas outlet end of the chamber 110. The gas inlet ends of the first branch exhaust pipe 1802 and the second branch exhaust pipe 1804 are respectively connected to an exhaust end of the first main exhaust pipe 1801. The exhaust ends of the first branch exhaust pipe 1802 and the second branch exhaust pipe 1804 are respectively connected to a gas inlet end of the second main exhaust pipe 1806. The low-pressure control device 180 further includes a main valve 1803, a bypass pneumatic valve 1805 and a vacuum pump 1807. The main valve 1803 may correspond to the MV valve in FIG. 4, such as an electric valve. The main valve 1803 is used to control an air pressure inside the chamber 110 when the chamber 110 is in a process state. The main valve 1803 is provided on the first branch exhaust pipe 1802. The bypass pneumatic valve 1805 is used to control an air pressure inside the chamber 110 when the chamber 110 is in a non-process state. The bypass pneumatic valve 1805 is provided on the second branch exhaust pipe 1804. The vacuum pump 1807 is used to extract gas inside the chamber 110. An end of the vacuum pump 1807 is connected to the exhaust end of the second main exhaust pipe 1806, and another end is connected to an exhaust gas treatment device 190.

Specifically, the first main exhaust pipe 1801 can be connected to the general exhaust pipe 160. When low-pressure control of the chamber 110 is required, the following operations can be performed to ensure that the air pressure inside the chamber 110 remains in a low-pressure state: controlling the first branch exhaust pipe 1802 to be in an open state and the second branch exhaust pipe 1804 to be in a closed state by controlling the main valve 1803 to be in an open state and the bypass pneumatic valve 1805 to be in a closed state; and enabling the vacuum pump 1807 to extract gas via the vacuum pump 1807, such that the gas in the chamber 110 flows through the general exhaust pipe 160 into the first main exhaust pipe 1801 and the first branch exhaust pipe 1802, then flows through the first main exhaust pipe 1801 and the first branch exhaust pipe 1802 into the vacuum pump 1807, and then flows through the vacuum pump 1807 into the exhaust gas treatment device 190. When low-pressure control of the chamber 110 is not required, the second branch exhaust pipe 1804 can be controlled to be in the open state and the first branch exhaust pipe 1802 in the closed state by controlling the main valve 1803 to be in the closed state and the bypass pneumatic valve 1805 to be in the open state. The gas in the chamber 110 is exhausted via the second branch exhaust pipe 1804. The exhausted gas can flow into the exhaust gas treatment device 190.

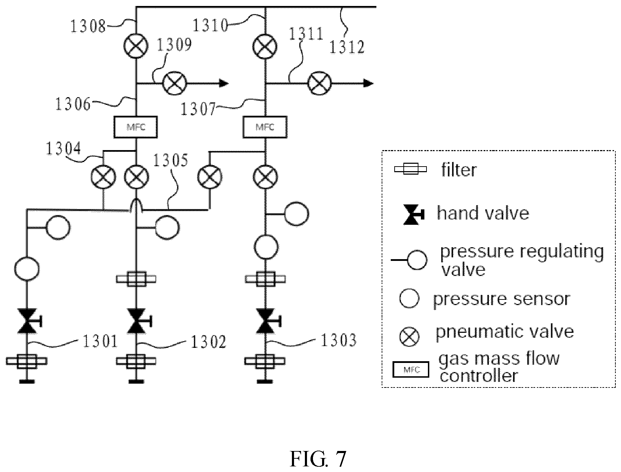

In some embodiments, as shown in FIGs. 4 and 7, the low-pressure gas intake device 130 includes a second nitrogen gas supply pipe 1301, a fluorine gas supply pipe 1302, a special gas supply pipe 1303, a fourth mixed gas supply pipe 1306, a fifth mixed gas supply pipe 1307, a sixth mixed gas supply pipe 1312, a first mixed branch gas supply pipe 1308, a second mixed branch gas supply pipe 1309, a third mixed branch gas supply pipe 1310 and a fourth mixed branch gas supply pipe 1311. The exhaust ends of the second nitrogen gas supply pipe 1301 are respectively connected to gas inlet ends of the third nitrogen branch gas supply pipe 1304 and the fourth nitrogen branch gas supply pipe 1305. The exhaust ends of the third nitrogen branch gas supply pipe 1304 and the fluorine gas supply pipe 1302 are respectively connected to a gas inlet end of the fourth mixed gas supply pipe 1306. The exhaust ends of the fourth nitrogen branch gas supply pipe 1305 and the special gas supply pipe 1303 are respectively connected to a gas inlet end of the fifth mixed gas supply pipe 1307. The exhaust ends of the fourth mixed gas supply pipe 1306 are respectively connected to gas inlet ends of the first mixed branch gas supply pipe 1308 and the second mixed branch gas supply pipe 1309. The exhaust ends of the fifth mixed gas supply pipe 1307 are respectively connected to gas inlet ends of the third mixed branch gas supply pipe 1310 and the fourth mixed branch gas supply pipe 1311. The exhaust ends of the first mixed branch gas supply pipe 1308 and the third mixed branch gas supply pipe 1310 are connected to a gas inlet end of the sixth mixed gas supply pipe 1312. A gas outlet end of the sixth mixed gas supply pipe 1312 is connected to a gas inlet end of the low-pressure gas injection pipe 150. The exhaust ends of the second mixed branch gas supply pipe 1309 and the fourth mixed branch gas supply pipe 1311 are respectively connected to the second main exhaust pipe 1806. The second nitrogen gas supply pipe 1301 is provided with a filter, a hand valve, a pressure regulating valve and a pressure sensor in sequence. The fluorine gas supply pipe 1302 is provided with a filter, a hand valve, a filter, a pressure sensor and a pneumatic valve in sequence. The special gas supply pipe 1303 is provided with a filter, a hand valve, a filter, a pressure regulating valve, a pressure sensor and a pneumatic valve in sequence. Each of the third nitrogen branch gas supply pipe 1304, the fourth nitrogen branch gas supply pipe 1305, the first mixed branch gas supply pipe 1308, the second mixed branch gas supply pipe 1309, the third mixed branch gas supply pipe 1310 and the fourth mixed branch gas supply pipe 1311 is provided with a pneumatic valve. Each of the fourth mixed gas supply pipe 1306 and the fifth mixed gas supply pipe 1307 is provided with a gas mass flow controller.

Specifically, the second nitrogen gas supply pipe 1301, the fluorine gas supply pipe 1302 and the special gas supply pipe 1303 can be respectively connected to the nitrogen gas source, fluorine gas source and special gas source. When the air pressure inside the chamber 110 is controlled to be at the low-pressure state by the low-pressure control device 180, nitrogen, fluorine and special gas can be supplied to the chamber 110 respectively via the second nitrogen gas supply pipe 1301, the fluorine gas supply pipe 1302 and the special gas supply pipe 1303. A portion of the nitrogen supplied via the second nitrogen supply pipe 1301 can flow through the third nitrogen branch gas supply pipe 1304 into the fourth mixed gas supply pipe 1306, and the fluorine gas supplied via the fluorine gas supply pipe 1302 can also flow into the fourth mixed gas supply pipe 1306. The nitrogen and fluorine are mixed in the fourth mixed gas supply pipe 1306. Another portion of the nitrogen supplied via the second nitrogen supply pipe 1301 can flow through the fourth nitrogen branch gas supply pipe 1305 into the fifth mixed gas supply pipe 1307, and the special gas supplied via the special gas supply pipe 130 can also flow into the fifth mixed gas supply pipe 1307. The nitrogen and the special gas are mixed in the fifth mixed gas supply pipe 1307. Thereafter, the mixed nitrogen and fluorine gas flows through the first mixed branch gas supply pipe 1308 into the sixth mixed gas supply pipe 1312. The mixed nitrogen and special gas flows through the third mixed branch gas supply pipe 1310 into the sixth mixed gas supply pipe 1312, where they are mixed, and then flow through the low-pressure gas injection pipe 150 into the chamber 110.

Wherein, the filters provided on the second nitrogen gas supply pipe 1301, the fluorine gas supply pipe 1302 and the special gas supply pipe 1303 can respectively filter the gas in their respective pipes. The hand valves provided on the second nitrogen gas supply pipe 1301, the fluorine gas supply pipe 1302 and the special gas supply pipe 1303 can respectively open and close their respective pipes such that the gas flows or stops flowing in the pipes. The pressure regulating valves provided on the second nitrogen gas supply pipe 1301, the fluorine gas supply pipe 1302 and the special gas supply pipe 1303 can respectively adjust the pressure in their respetive pipes. Thee pressure sensors provided on the second nitrogen gas supply pipe 1301, the fluorine gas supply pipe 1302 and the special gas supply pipe 1303 can respectively detect the pressure in their respective pipes.

The gas mass flow controller provided on the fourth mixed gas supply pipe 1306 can precisely measure and control the mass/flow rate of the mixed nitrogen and fluorine. The gas mass flow controller provided on the fifth mixed gas supply pipe 1307 can precisely measure and control the mass/flow rate of the mixed nitrogen and special gas. Accordingly, the gas flow rate involved in the reaction in the chamber 110 can be controlled within a very precise range, allowing the reaction to proceed according to the set process parameters, which is helpful to improve the consistency and quality of the products. Taking chemical vapor deposition in silicon wafer manufacturing as an example, precisely controlling the mass flow of the reaction gas can ensure that the film deposited on the silicon wafer is uniform in thickness and stable in performance.

In some embodiments, the special gas supplied by the special gas supply pipe 1303 can be determined according to actual conditions, for example, it can be silane gas involved in the reaction to deposit a thin film on the silicon wafer, which is not limited.

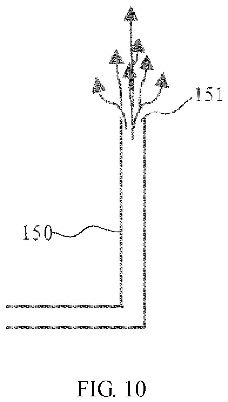

In some embodiments, as shown in FIGs. 8 and 10, the low-pressure gas injection pipe 150 is L-shaped. One end of the low-pressure gas injection pipe 150 is connected to the low-pressure gas intake device 130, and another end thereof is a gas outlet 151 extending upward in the height direction of the chamber 110. The height of the low-pressure gas injection pipe 150 is lower than the height of the lowest wafer in the chamber 110.

The low-pressure gas intake device 130 can be controlled to maintain the air pressure inside the chamber 110 in a low-pressure state by controlling its components like the main valve 1803 and the vacuum pump 1807. Consequently, after the gas flows through the low-pressure gas injection pipe 150 into the chamber 110, it first flows upward to the top of the chamber 110, and then flows downward to the gas outlet end of the chamber 110. Therefore, by providing an L-shaped low-pressure gas injection pipe 150, the requirement of the low-pressure process treatment for the entry of the mixed gas from the sixth mixed gas supply pipe 1312 into the chamber 110 can be met.

It can be understood that the gas flowing into the exhaust gas treatment device 190 can be recovered or removed and the harmful components of the gas can be reduced under the action of the exhaust gas treatment device 190, enabling it to meet the emission standards after treatment and reduce air pollution.

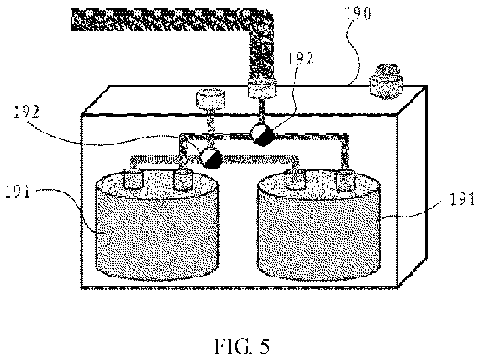

In some embodiments, as shown in FIG. 5, the exhaust gas treatment device 190 comprises at least two exhaust gas treatment chambers 191. One exhaust gas treatment chamber 191 can be switched to another exhaust gas treatment chamber 191 when the exhaust gas treatment chamber 191 breaks down.

Specifically, the two exhaust gas treatment chambers 191 can be connected through pipelines. Each of the exhaust gas treatment chambers 191 is provided with a three-way valve 192. Automatic change-over between the two exhaust gas treatment chambers 191 can be performed by the three-way valves 192, such that when one exhaust gas treatment chamber 191 breaks down, the exhaust gas treatment chamber 191 can be switched to another exhaust gas treatment chamber 191. As a result, normal operation of the exhaust gas treatment device 190 can be maintained.

In some embodiments, the furnace tube may further comprise a control element, which receives control operations from users. The control element can control the normal-pressure gas intake device 120 and the normal-pressure control device 170 to be in an enabled state, and control the low-pressure gas intake device 130 and the low-pressure control device 180 to be in a closed state according to the control operations, such that the wafers in the furnace tube can be subjected to normal-pressure process treatment. The control element can also control the normal-pressure gas intake device 120 and the normal-pressure control device 170 to be in the closed state, and control the low-pressure gas intake device 130 and the low-pressure control device 180 to be in the enabled state, such that the wafers in the furnace tube can be subjected to low-pressure process treatment.

Wherein, the control element may be a control panel, a control button, etc., which is not limited.

In some embodiments, when switching from low-pressure process treatment to normal-pressure process treatment, mixed gas of fluorine and nitrogen can be continuously supplied into the chamber 110 through the low-pressure gas intake device 130, and the film layer generated in the chamber 110 during the low-pressure process can be removed by fluorine. The chemical reaction equation can be as follows:

Si + 2F₂ → SiF₄ (exothermic reaction).

The above reaction is an exothermic reaction. Therefore, it is possible to determine whether the reaction has completed by detecting the temperature inside the chamber 110, and whether the film layer inside the chamber 110 has been completely removed. For example, a temperature sensor can be configured to detect the temperature inside the chamber 110. When the film layer inside the chamber 110 is completely removed, the temperature inside the chamber 110 will drop. If the temperature sensor detects that the temperature inside the chamber 110 drops to a preset temperature or below, it means that the film layer inside the chamber 110 has been completely removed. The preset temperature can be set according to the actual heat release of the chemical reaction. For example, the preset temperature can be 400°C or any other suitable temperature, which is not limited.

After it is detected that the film layer inside the chamber 110 has been completely removed, the low-pressure gas intake device 130 stops supplying gas to the chamber 110, and the normal-pressure gas intake device 120 can be enabled to introduce nitrogen into the chamber 110 such that the interior of the chamber is switched from a low-pressure environment to a normal-pressure state. Then, the normal-pressure control device 170 is enabled to maintain the interior of chamber 110 in the normal-pressure state. Consequently, the switch from the low-pressure process treatment to normal-pressure process treatment is completed while preventing the gas in the exhaust pipe from backflowing into the chamber 110 during the switch of the furnace tube from the low-pressure process mode to the normal-pressure process mode, and thus avoiding contamination.

According to another aspect of the present disclosure, a using method of a furnace tube is provided, comprising the steps of:
keeping the normal-pressure gas intake device and the normal-pressure control device enabled and the low-pressure gas intake device and the low-pressure control device closed such that a wafer is subjected to an normal-pressure process in the chamber.

Wherein, the furnace tube can be implemented as the furnace tube mentioned above, and reference can be made to the introduction mentioned above, which will not be repeated here.

In some embodiments, controlling a working environment in the chamber to switch from a low-pressure environment to a normal-pressure environment comprises the steps of: controlling the low-pressure gas intake device to introduce a mixed gas of fluorine gas and nitrogen gas into the chamber to completely remove a film layer formed on an inner wall of the chamber; disabling the controlling of the low-pressure gas intake device and the low-pressure control device, and enabling the normal-pressure gas intake device to introduce nitrogen gas to switch interior of the chamber from a low-pressure environment into a normal-pressure state; enabling the normal-pressure control device.

According to another aspect of the present disclosure, a using method of a furnace tube is provided, wherein the low-pressure gas intake device and the low-pressure control device are kept enabled, and the normal-pressure gas intake device and the normal-pressure control device are kept disabled such that a wafer is subjected to a low-pressure process treatment in the chamber.

Wherein, the furnace tube can be implemented as the furnace tube mentioned above, and reference can be made to the introduction mentioned above, which will not be repeated here.

Given above, according to the furnace tube and the using method thereof in the embodiments of the present disclosure, the wafer in the chamber can be subjected to the normal-pressure process treatment by configuring the normal-pressure gas intake device to supply gas to the chamber and the normal-pressure control device to control the gas pressure in the chamber. The wafer in the chamber can also be subjected to the low-pressure process treatment by configuring the low-pressure gas intake device to supply gas to the chamber and the low-pressure control device to control the air pressure in the chamber. As a result, compatibility of the normal-pressure and low-pressure process treatment through one furnace tube is achieved.

Although the above example embodiments have been described with reference to the drawings, it is to be understood that the above-described example embodiments are for illustrative purposes only and are not intended to limit the scope of the present disclosure thereto. Those of ordinary skill in the art can make various variations and modifications therein but not deviate from the scope and spirit of the present disclosure. All these variations and modifications are intended to be included within the scope of the present disclosure as claimed by the claims attached.

Similarly, it is to be understood that respective features of the present disclosure are sometimes grouped together to the single embodiment, the drawing, or the depiction thereof in the description of the exemplary embodiments of the present disclosure, in order to simplify the present disclosure and facilitate understanding of one or more aspects of the disclosure. However, the method of the present disclosure shall not be explained to reflect the following intention, that is, the claimed present disclosure claims more features than those explicitly recited in each claim. To be more accurate, as reflected by the corresponding claims, the inventive ideas thereof lie in that the corresponding technical problem may be resolved with the feature fewer than all features of the single embodiment of some disclosure. Thus, the claims complying with the embodiments are hereby explicitly incorporated into the embodiments, wherein each claim itself serves as an independent embodiment of the present disclosure.

In addition, it would be understood by those skilled in the art that although some embodiments described herein comprise some features that are included in other embodiments but not other features, the combination of the features of different embodiments means falling into the scope of the present disclosure and forming different embodiments. For example, in the claims, any one of the claimed embodiments may be used in a manner of an arbitrary combination.

It should be noted that the abovementioned embodiments illuminate the present disclosure and do not pose a limitation on the present disclosure. Moreover, those skilled in the art may design alternative embodiments without separating from the scope of the claims attached. In the claims, any reference symbols between parentheses shall not be configured as limitation on the claims. The use of the words "first", "second" and "third" does not indicate any order, and these words may be construed as names.

## Claims

1. A furnace tube, comprising:
a chamber (110) for processing a wafer;
a normal-pressure gas intake device (120) and a low-pressure gas intake device (130) configured to supply gas to the chamber (110), wherein each of the normal-pressure gas intake device (120) and the low-pressure gas intake device (130) is independently connected to the chamber (110);
an normal-pressure control device (170) and a low-pressure control device (180) configured to control an air pressure inside the chamber (110), wherein each of the normal-pressure control device (170) and the low-pressure control device (180) is configured to independently control the air pressure in the chamber (110);
a normal-pressure gas injection pipe (140) located inside the chamber (110) and connected to the normal-pressure gas intake device (120), and a low-pressure gas injection pipe (150) located inside the chamber (110) and connected to the low-pressure gas intake device (130).

2. The furnace tube of claim 1, wherein the chamber (110) comprises a gas inlet end and a gas outlet end;
wherein the normal-pressure gas intake device (120) is connected to the normal-pressure gas injection pipe (140) via the gas inlet end, and the low-pressure gas intake device (130) is connected to the low-pressure gas injection pipe (150) via the gas inlet end;
wherein the normal-pressure control device (170) and the low-pressure control device (180) are connected to the gas outlet end, respectively.

3. The furnace tube of claim 2, wherein the low-pressure control device (180) comprises:
a first main exhaust pipe (1801) , a first branch exhaust pipe (1802) , a second branch exhaust pipe (1804) and a second main exhaust pipe (1806) for providing gas channels, wherein a gas inlet end of the first main exhaust pipe (1801) is connected to the gas outlet end, gas inlet ends of the first branch exhaust pipe (1802) and the second branch exhaust pipe (1804) are respectively connected to an exhaust end of the first main exhaust pipe (1801) , and exhaust ends of the first branch exhaust pipe (1802) and the second branch exhaust pipe (1804) are respectively connected to a gas inlet end of the second main exhaust pipe (1806);
a main valve (1803) for controlling the air pressure inside the chamber (110) when the chamber (110) is in a process state, wherein the main valve (1803) is provided on the first branch exhaust pipe (1802) ;
a bypass pneumatic valve (1805) for controlling the air pressure inside the chamber (110) when the chamber (110) is in a non-process state, wherein the bypass pneumatic valve (1805) is provided on the second branch exhaust pipe (1804) ;
a vacuum pump (1807) for pumping gas inside the chamber (110) , wherein an end of the vacuum pump (1807) is connected to the exhaust end of the second main exhaust pipe (1806) and another end of the vacuum pump (1807) is connected to an exhaust gas treatment device (190) .

4. The furnace tube of claim 2, wherein the normal-pressure control device (170) comprises:
a third main exhaust pipe (1701) , a mixed drainage pipe (1703) , a drain pipe (1705) , a first branch exhaust pipe (1706) , a second branch exhaust pipe (1709) , a third branch exhaust pipe (1712) and a fourth branch exhaust pipe (1715) , wherein an exhaust end of the third main exhaust pipe (1701) is connected to one end of a condenser (1702) , another end of the condenser (1702) is connected to an inlet of the mixed drainage pipe (1703) , outlets of the mixed drainage pipe (1703) are respectively connected to an inlet of the drain pipe (1705) and gas inlet ends of the first branch exhaust pipe (1706) , the second branch exhaust pipe (1709), the third branch exhaust pipe (1712) and the fourth branch exhaust pipe (1715), and exhaust ends of the first branch exhaust pipe (1706) , the second branch exhaust pipe (1709) , the third branch exhaust pipe (1712) and the fourth branch exhaust pipe (1715) are all connected to the exhaust gas treatment device (190) ;
wherein the drain pipe (1705) is provided with a water tank (1704) and a pneumatic valve (1717) , the first branch exhaust pipe (1706) is provided with a pneumatic valve (1707) and an absolute pressure control valve (1708) , the second branch exhaust pipe (1709) is provided with a pneumatic valve (1710) and a relative pressure control valve (1711) , the third branch exhaust pipe (1712) is provided with an automatic valve (1713) and a one-way valve (1714) , and the fourth branch exhaust pipe (1715) is provided with a pneumatic valve (1716) ;
wherein the relative pressure control valve (1711) is used to control the air pressure inside the chamber (110) when a temperature inside the chamber (110) is higher than a first set temperature;
wherein the absolute pressure control valve (1708) is used to control the air pressure inside the chamber (110) when the temperature inside the chamber (110) is lower than or equal to the first set temperature.

5. The furnace tube of claim 2, wherein the normal-pressure gas injection pipe (140) comprises a main body portion (141) extending in a height direction of the chamber (110) and a connection portion (142) connected to the normal-pressure gas intake device (120) , wherein the main body portion (141) is evenly provided with a plurality of nozzles (143) , the gas inlet end is located at a bottom of the chamber (110) , sizes of the nozzles (143) increase with their distances from the gas inlet end, such that nozzles farther from the gas inlet end are larger in size, and a height of the uppermost nozzle is greater than or equal to a height of an uppermost wafer in the chamber (110) .

6. The furnace tube of claim 2, wherein the low-pressure gas injection pipe (150) is L-shaped, wherein an end of the low-pressure gas injection pipe (150) is connected to the low-pressure gas intake device (130) , and another end of the low-pressure gas injection pipe (150) is a gas outlet (151) extending upward in a height direction of the chamber (110) , and a height of the low-pressure gas injection pipe (150) is lower than a height of a lowest wafer in the chamber (110) .

7. The furnace tube of claim 1, wherein the normal-pressure gas intake device (120) comprises:
a first nitrogen gas supply pipe (1201) , an oxygen gas supply pipe (1202) , a hydrogen gas supply pipe (1203), a first mixed gas supply pipe (1206), a second mixed gas supply pipe (1207) and a third mixed gas supply pipe (1208) ;
wherein exhaust ends of the first nitrogen gas supply pipe (1201) are respectively connected to gas inlet ends of a first nitrogen branch gas supply pipe (1204) and a second nitrogen branch gas supply pipe (1205) , exhaust ends of the first nitrogen branch gas supply pipe (1204) and the oxygen gas supply pipe (1202) are respectively connected to a gas inlet end of the first mixed gas supply pipe (1206) , exhaust ends of the second nitrogen branch gas supply pipe (1205) and the hydrogen gas supply pipe (1203) are respectively connected to a gas inlet end of the second mixed gas supply pipe (1207), exhaust ends of the first mixed gas supply pipe (1206) and the second mixed gas supply pipe (1207) are respectively connected to a gas inlet end of the third mixed gas supply pipe (1208) , and an exhaust end of the third mixed gas supply pipe (1208) is connected to a gas inlet end of the normal-pressure gas injection pipe (140) ;
wherein each of the first nitrogen gas supply pipe (1201) , the oxygen gas supply pipe (1202) and the hydrogen gas supply pipe (1203) is provided with a filter, a hand valve, a pressure regulating valve and a pressure sensor in sequence, the hydrogen gas supply pipe (1203) is further provided with a pneumatic valve behind the pressure sensor, and each of the first nitrogen branch gas supply pipe (1204) and the second nitrogen branch gas supply pipe (1205) is provided with a pneumatic valve;
wherein each of the first mixed gas supply pipe (1206) and the second mixed gas supply pipe (1207) is provided with a gas mass flow controller and a pneumatic valve, and the third mixed gas supply pipe (1208) is provided with an igniter (1209) .

8. The furnace tube of claim 3, wherein the low-pressure gas intake device (130) comprises:
a second nitrogen gas supply pipe (1301) , a fluorine gas supply pipe (1302) , a special gas supply pipe (1303), a fourth mixed gas supply pipe (1306), a fifth mixed gas supply pipe (1307), a sixth mixed gas supply pipe (1312), a first mixed branch gas supply pipe (1308), a second mixed branch gas supply pipe (1309), a third mixed branch gas supply pipe (1310), and a fourth mixed branch gas supply pipe (1311) ;
wherein exhaust ends of the second nitrogen gas supply pipe (1301) are respectively connected to gas inlet ends of the third nitrogen branch gas supply pipe (1304) and the fourth nitrogen branch gas supply pipe (1305) , exhaust ends of the third nitrogen branch gas supply pipe (1304) and the fluorine gas supply pipe (1302) are respectively connected to a gas inlet end of the fourth mixed gas supply pipe (1306) , exhaust ends of the fourth nitrogen branch gas supply pipe (1305) and the special gas supply pipe (1303) are respectively connected to a gas inlet end of the fifth mixed gas supply pipe (1307) , exhaust ends of the fourth mixed gas supply pipe (1306) are respectively connected to gas inlet ends of the first mixed branch gas supply pipe (1308) and the second mixed branch gas supply pipe (1309) , exhaust ends of the fifth mixed gas supply pipe (1307) are respectively connected to gas inlet ends of the third mixed branch gas supply pipe (1310) and the fourth mixed branch gas supply pipe (1311) , exhaust ends of the first mixed branch gas supply pipe (1308) and the third mixed branch gas supply pipe (1310) are connected to a gas inlet end of the sixth mixed gas supply pipe (1312), a gas outlet end of the sixth mixed gas supply pipe (1312) is connected to a gas inlet end of the low-pressure gas injection pipe (150) , and exhaust ends of the second mixed branch gas supply pipe (1309) and the fourth mixed branch gas supply pipe (1311) are respectively connected to the second main exhaust pipe (1806) ;
wherein the second nitrogen gas supply pipe (1301) is provided with a filter, a hand valve, a pressure regulating valve and a pressure sensor in sequence, the fluorine gas supply pipe (1302) is provided with a filter, a hand valve, a filter, a pressure sensor and a pneumatic valve in sequence, the special gas supply pipe (1303) is provided with a filter, a hand valve, a filter, a pressure regulating valve, a pressure sensor and a pneumatic valve in sequence, each of the third nitrogen branch gas supply pipe (1304) , the fourth nitrogen branch gas supply pipe (1305) , the first mixed branch gas supply pipe (1308) , the second mixed branch gas supply pipe (1309) , the third mixed branch gas supply pipe (1310) and the fourth mixed branch gas supply pipe (1311) is provided with a pneumatic valve, and each of the fourth mixed gas supply pipe (1306) and the fifth mixed gas supply pipe (1307) is provided with a gas mass flow controller.

9. The furnace tube of claim 3 or 4, wherein the exhaust gas treatment device (190) comprises at least two exhaust gas treatment chambers (191) , wherein one exhaust gas treatment chamber (191) can be switched to another exhaust gas treatment chamber (191) when the exhaust gas treatment chamber (191) breaks down.

10. A using method of the furnace tube of claim 1, comprising the steps of:
enabling the normal-pressure gas intake device (120) and the normal-pressure control device (170), and disabling the low-pressure gas intake device (130) and the low-pressure control device (180) such that a wafer in the chamber (110) is subjected to a normal-pressure process.

11. The using method of claim 10, wherein controlling a working environment in the chamber (110) to switch from a low-pressure environment to a normal-pressure environment comprises the steps of:
controlling the low-pressure gas intake device (130) to introduce a mixed gas of fluorine gas and nitrogen gas into the chamber to completely remove a film layer formed on an inner wall of the chamber (110);
disabling the low-pressure gas intake device (130) and the low-pressure control device (180), and enabling the normal-pressure gas intake device (120) to introduce nitrogen gas to switch interior of the chamber (110) from a low-pressure environment to an normal-pressure state;
enabling the normal-pressure control device (170).

12. A using method of the furnace tube of claim 1, wherein the low-pressure gas intake device (130) and the low-pressure control device (180) are kept enabled, and the normal-pressure gas intake device (120) and the normal-pressure control device (170) are kept disabled such that a wafer in the chamber (110) is subjected to a low-pressure process treatment.
